# EUROPEAN PATENT APPLICATION

(11) **EP 1 956 644 A1**
(43) Date of publication of application: **13.08.2008**
(21) Application number: 06833742.7
(22) Date of filing: 30.11.2006
(51) Int. Cl.: H01L 21/308, H01L 21/304, H01L 29/78

(54) **SEMICONDUCTOR SURFACE TREATMENT AGENT**

(30) Priority: 01.12.2005 JP 2005348105
(71) Applicant: MITSUBISHI GAS CHEMICAL COMPANY, INC., Chiyoda-ku, Tokyo 100-8324 (JP)
(72) Inventor: YAGUCHI, Kazuyoshi, Tokyo 125-0051 (JP); SHIMADA, Kenji, Tokyo 125-0051 (JP); ABE, Kojiro, Tokyo 125-0051 (JP)
(74) Representative: Gille Hrabal Struck Neidlein Prop Roos
(86) International application number: PCT/JP2006/323939
(87) International publication number: WO 2007/063942

(57) **Abstract**

A semiconductor surface treatment agent containing a fluorine compound, a water-soluble organic solvent and an inorganic acid, with the balance being water and a method for manufacturing a semiconductor device by etching a high dielectric constant insulating material using the subject semiconductor surface treatment agent are provided. According to the present invention, it is possible to selectively and efficiently etch a high dielectric constant insulating material to be used in a transistor formation process of the semiconductor device manufacture; and it is also possible to achieve etching with ease within a short period of time even for a high dielectric constant insulating material to which etching is hardly applied.

## Description

### Technical Field

The present invention relates to a semiconductor surface treatment agent which is useful as an etching solution of a high dielectric constant insulating material to be used in a transistor formation process, as a developing solution or a release agent solution of a resist to be used in a lithography process and further as a cleaning solution after ashing in the semiconductor device manufacture and to a method for manufacturing a semiconductor device using the same.

### Background Art

Fluorine compound-containing compositions have hitherto been used as a semiconductor surface treatment agent in the semiconductor device manufacture (Patent Document 1).

Now, in recent semiconductor devices, following high integration and thinning of a gate insulating layer, an increase in tunnel current through an insulating layer at the time of biasing a gate voltage to a transistor has become problematic. In order to suppress this problematic increase in tunnel current, there is a method of employing a high dielectric constant insulating material having a dielectric constant of 10 or more in place of silicon oxide having a dielectric constant of 3. 9. As such a high dielectric constant insulating material, rare earth element oxides such as Al₂O₃, HfO₂, Y₂O₃ and ZrO₂, or oxides of a lanthanoid series element are studied as a candidate material. By using such a high dielectric constant insulating material, even when the gate length is made minute, it is possible to control the thickness of the gate insulating layer so as to prevent tunnel current while maintaining the capacitance of the gate insulating material in conformity with the scaling law.

For the formation of a transistor using such a high dielectric constant insulating material, a process for selectively etching the high dielectric constant insulating material is essential. In the case where the conventional dry etching method using a plasma gas is applied to this process, insulating materials such as silicon oxide and nitride and polysilicon and metallic materials are etched, whereby precise processing becomes difficult. For that reason, a wet etching method with a chemical liquid having low corrosion to insulating materials such as silicon oxide and nitride and polysilicon and metallic materials and having a performance capable of selectively and efficiently etching only a high dielectric constant insulating material has been watched.

In the case where this wet etching method is applied, it has become clear that a high dielectric constant insulating material having a high fabrication temperature or a long fabrication time is etched with difficulty as compared with a high dielectric constant insulating material having a low fabrication temperature or a short fabrication time.
In general, as a semiconductor surface treatment agent for etching a high dielectric constant insulating material, for example, an etching solution composed of hydrogen fluoride, at least one member selected among hetero atom-containing organic solvents and organic acids and water, with a concentration of water being not more than 40 % by weight, and an etching method are proposed (Patent Document 2).
The subject chemical liquid is low in an etching power for a high dielectric constant insulating material, and it may not be said that this chemical liquid has sufficient etching ability against the high dielectric constant insulating material. Besides, patents regarding a semiconductor surface treatment agent for a high dielectric constant insulating material have been applied. However, under such a circumstance that a high dielectric constant insulating material having a high fabrication temperature or a high fabrication time has been the main current, a semiconductor surface treatment agent which is thoroughly satisfied with etching ability against such a high dielectric constant insulating material has not been developed yet.
In view of this matter, in order to achieve etching with ease within a short period of time even for a high dielectric constant insulating material to which etching is hardly applied, the development of a semiconductor surface treatment agent with an enhanced etching power against the high dielectric constant insulating material has been eagerly desired.

Patent Document 1: JP-A-7-201794

Patent Document 2: JP-A-2003-332297

### Disclosure of the Invention

### Problems that the Invention is to Solve

The present invention is to provide a semiconductor surface treatment agent which is suitable for a manufacturing process of a semiconductor. In particular, the present invention is to provide a semiconductor surface treatment agent which, in manufacturing a semiconductor device using a high dielectric constant insulating material which is indispensable for a technology for suppressing tunnel current of a transistor, has low corrosion to insulating materials such as silicon oxide and nitride and polysilicon and metallic materials, is able to selectively and efficiently etch a high dielectric constant insulating material and is also able to achieve etching with ease within a short period of time even for a high dielectric constant insulating material to which etching is hardly applied and a method for manufacturing a semiconductor device using the same.

### Means for Solving the Problems

In order to solve the foregoing problems, the present inventors made extensive and intensive investigations. As a result, it has been found that a semiconductor surface treatment agent comprising a fluorine compound, a water-soluble organic solvent and an inorganic acid, with the balance being water has extremely excellent characteristics that it is able to achieve minute processing of a high dielectric insulating material and that it has low corrosion to insulating materials such as silicon oxide and nitride and polysilicon and metallic materials; and that the subject semiconductor surface treatment agent is able to achieve etching with ease within a short period of time even for a film to which etching is hardly applied, leading to accomplishment of the present invention.

That is, the present invention is concerned with a semiconductor surface treatment agent comprising a fluorine compound, a water-soluble organic solvent and an inorganic acid, with the balance being water. Furthermore, the present invention is concerned with a method for manufacturing a semiconductor device comprising etching a high dielectric constant insulating material using the foregoing semiconductor surface treatment agent.

### Advantages of the Invention

By etching a high dielectric constant insulating material using the semiconductor surface treatment agent of the present invention, not only it is possible to achieve selective etching of a high dielectric constant insulating material, which is difficultly achieved by only the conventional etching method using a plasma gas, but it is possible to suppress corrosion to insulating materials such as silicon oxide and nitride and polysilicon and metallic materials. Furthermore, it is possible to achieve etching with ease within a short period of time even for a high dielectric constant insulating material under a severe condition, to which etching has been hardly applied by the conventional method.

### Best Modes for Carrying Out the Invention

Examples of the fluorine compound to be used in the present invention include hydrofluoric acid; ammonium fluoride; acidic ammonium fluoride; cerium fluoride; silicon tetrafluoride; fluorosilicic acid; nitrogen fluoride; phosphorus fluoride; vinylidene fluoride; boron trifluoride; borofluoric acid; fluorine compound salts such as ammonium fluoroborate, monoethanolamine hydrofluoride, methylamine hydrofluoride, ethylamine hydrofluoride, propylamine hydrofluoride, tetramethylammonium fluoride, tetraethylammonium fluoride, triethylmethylammonium fluoride, trimethylhydroxyethylammonium fluoride, tetraethoxyammonium fluoride and methyltriethoxyammonium fluoride; and metal-fluorine compounds such as lithium fluoride, sodium fluoride, acidic sodium fluoride, potassium fluoride, acidic potassium fluoride, potassium fluorosilicate, potassium hexafluorophosphate, magnesium fluoride, calcium fluoride, strontium fluoride, barium fluoride, zinc fluoride, aluminum fluoride, stannous fluoride, lead fluoride and antimony trifluoride. Of these, preferred fluorine compounds are hydrofluoric acid, ammonium fluoride, acidic ammonium fluoride, tetramethylammonium fluoride, sodium fluoride and potassium fluoride.

The concentration of the fluorine compound in the semiconductor surface treatment agent is in the range of from 0.001 to 10 % by weight, and preferably from 0.05 to 8 % by weight. When the concentration of the fluorine compound is 0.001 % by weight or more, a favorable etching rate of the high dielectric constant insulating material is obtainable, whereas when it is not more than 10 % by weight, corrosion to insulating materials such as silicon oxide and nitride and polysilicon and metallic materials is not generated.

The foregoing fluorine compound to be used in the present invention may be used singly or in combination of two or more kinds thereof. Also, when the concentration of the foregoing fluorine compound is increased, the etching rate of the high dielectric constant insulating material can be increased, and therefore, it is preferable that the concentration of the fluorine compound is increased to an extent that insulating materials such as silicon oxide and nitride and metallic materials are not corroded.

Examples of the water-soluble organic solvent to be used in the present invention include lactones such as γ-butyrolactone; sulfoxides such as dimethyl sulfoxide; nitriles such as acetonitrile and benzonitrile; alcohols such as methanol, ethanol and isopropanol; esters such as methyl acetate and ethyl acetate; glycol ethers such as diethylene glycol monomethyl ether and dipropylene glycol monomethyl ether; and amides such as dimethylformamide and dimethylacetamide. Of these, preferred water-soluble organic solvents are glycol ethers and alcohols.

The concentration of the water-soluble organic solvent in the semiconductor surface treatment agent is in the range of from 1 to 99 % by weight, and preferably from 30 to 95 % by weight. When the concentration of the water-soluble organic solvent is 1 % by weight or more, effects by the addition of the water-soluble organic solvent are obtainable, whereas when it is not more than 99 % by weight, reduction of an etching power of the high dielectric constant insulating material is prevented from occurring.

The foregoing water-soluble organic solvent to be used in the present invention may be used singly or in combination of two or more kinds thereof. Also, by adding the foregoing water-soluble organic solvent, it is possible to selectively etch a high dielectric constant insulating material without causing corrosion of insulating materials such as silicon oxide and nitride and metallic materials.

Examples of the inorganic acid to be used in the present invention include sulfuric acid, nitric acid, hydrochloric acid, phosphoric acid, hypophosphorous acid, carbonic acid, sulfamic acid, boric acid, phosphonic acid, phosphinic acid, nitrous acid and amidosulfuric acid. Of these, sulfuric acid, nitric acid, hydrochloric acid, phosphoric acid, sulfamic acid, nitrous acid and amidosulfuric acid are preferable.

The concentration of the inorganic acid is properly determined depending upon the solubility in water to be contained and is preferably not more than 50 % by weight, and more preferably in the range of from 1 to 15 % by weight. When the concentration of the inorganic acid is not more than 50 % by weight, etching of a material which is basically not desirable to be damaged through etching, other than the high dielectric constant insulating material which is the target of etching, is prevented from occurring.

The foregoing inorganic acid to be used in the present invention may be used singly or in combination of two or more kinds thereof. Also, by adding the foregoing inorganic acid, insulating materials such as silicon oxide and nitride are hardly corroded. Furthermore, it is possible to efficiently etch the high dielectric constant insulating material. According to this matter, it is possible to achieve etching with ease within a short period of time even for a high dielectric constant insulating material under a severe condition, to which etching has been hardly applied.

Also, the acid to be contained in the semiconductor surface treatment agent of the present invention is preferably an inorganic acid. In a composition of a fluorine compound, a water-soluble organic solvent and an organic acid, which contains an organic acid in place of the inorganic acid, even in the case where an etching power of the high dielectric constant insulating material is low, or an etching power of the subject insulating material is high, insulating materials such as silicon oxide and nitride and metallic materials which should not be etched are corroded, selective etching of the high dielectric constant insulating material cannot be achieved.
The semiconductor surface treatment agent of the present invention is concerned with a combination of a fluorine compound, a water-soluble organic solvent and an inorganic acid and is able to etch the high dielectric constant insulating material with extremely high selectivity without utterly causing corrosion of insulating materials such as silicon oxide and nitride and metallic materials as compared with a composition having an organic acid combined therein.

Also, though the semiconductor surface treatment agent of the present invention is used in a step of entirely etching the high dielectric constant insulating material which is the target of etching, it is also useful for the removal of the high dielectric constant insulating material in an unetched area after achieving etching to an extent that insulating materials such as oxides and nitrides are not damaged by the conventional dry etching method using a plasma gas.

Furthermore, in the semiconductor surface treatment agent of the present invention, a conventionally used additive may be blended for the purposes of enhancing the etching performance, for example, enhancing wettability, inhibiting deposition of particles on a wafer or contamination of a metal after treating the wafer, or suppressing damages on an insulating material. Examples of such an additive include compounds having surface activating ability, compounds having chelating ability and water-soluble polymers. Also, these additives can be used so far as they are soluble in the semiconductor surface treatment agent and may be used singly or in combination of two or more kinds thereof.

Also, the pH of the semiconductor surface treatment agent of the present invention is not particularly limited and may be determined depending upon etching conditions, the kind of a semiconductor substrate to be used and the like. When the semiconductor surface treatment agent of the present invention is used under an alkaline condition, for example, ammonia, an amine and a quaternary ammonium hydroxide such as tetramethylammonium hydroxide may be added, whereas when it is used under an acidic condition, an inorganic acid, an organic acid or the like may be added.

The use temperature of the semiconductor surface treatment agent of the present invention is properly determined along with the use time depending upon the kind of a high dielectric constant insulating material which is the target of etching and the required etching amount. Also, as the cleaning system, for example, immersion cleaning in a batchwise system or spray or atomizing cleaning in a single wafer cleaning system can be employed.

The high dielectric constant insulating material may contain at least one member selected among Al₂O₃, CeO₃, Dy₂O₃, Er₂O₃, Eu₂O₃, Gd₂O₃, HfO₂, Ho₂O₃, La₂O₃, Lu₂O₃, Nb₂O₅, Nd₂O₃, Pr₂O₃, ScO₃, Sm₂O₃, Ta₂O₅, Tb₂O₃, TiO₂, Tm₂O₃, Y₂O₃, Yb₂O₃ and ZrO₂, with Al₂O₃, HfO₂, Ta₂O₅ and ZrO₂ being more preferable. Also, materials containing a silicon atom or a nitrogen atom in such a compound, or materials containing both a silicon atom and a nitrogen atom in such a compound can be applied. Furthermore, two of these materials of the foregoing materials may be mixed or contained in a stacked state.

### Examples

The present invention is more specifically described with reference to the following Examples and Comparative Examples, but it should not be construed that the present invention is limited to these Examples.

### Examples 1 to 13 and Comparative Examples 1 to 8

Etching performance was confirmed using a wafer sample prepared by forming th-SiO₂ which is an insulating material and further HfO₂ which is a high dielectric constant insulating material on a silicon wafer substrate. The results are shown in Table 1. th-SiO₂ refers to a silicon oxide film formed by thermal oxidation.
Evaluation criteria of HfO₂ which is a high dielectric constant insulating material are as follows.
○: The etching degree of HfO₂ was large (more than 30 angstroms/min).
× : The etching degree of HfO₂ was low (30 angstroms/min or less).

Also, etching performance of th-SO₂ was confirmed using a wafer sample prepared by forming th-SiO₂ which is an insulating material on a silicon wafer substrate. Also, the etching performance of th-SO₂ and the etching performance of HfO₂ were compared, and an etching selection ratio between HfO₂ and th-SiO₂ (HfO₂/th-SiO₂) was made a basis of judgment. The results are also shown in Table 1.
Evaluation criteria are as follows.
○: The etching selection ratio of HfO₂ and th-SiO₂ was larger than 1.
×: The etching selection ratio of HfO₂ and th-SiO₂ was 1 or smaller.

### Examples 14 to 26 and Comparative Examples 9 to 16

The treatment with a semiconductor surface treatment agent having a composition shown in Table 2 was carried out, thereby confirming Al₂O₃ which is a high dielectric constant insulating material. Also, the etching performance of th-SiO₂ which is an insulating material was confirmed and compared with the etching performance of Al₂O₃. The results are shown in Table 2.

### Examples 27 to 39 and Comparative Examples 17 to 24

The treatment with a semiconductor surface treatment agent having a composition shown in Table 3 was carried out, thereby confirming HfSiON which is a high dielectric constant insulating material. Also, the etching performance of th-SiO₂ which is an insulating material was confirmed and compared with the etching performance of HfSiON. The results are shown in Table 3.

In Tables 1, 2 and 3, it was confirmed that by applying the semiconductor surface treatment agent of the present invention, not only the desired etching of the high dielectric constant insulating material can be achieved, but the high dielectric constant insulating material can be selectively and efficiently etched without causing corrosion of silicon oxide and the like.

Also, it was confirmed that by applying the semiconductor surface treatment agent of the present invention, corrosion to metallic materials such as TiN is low.

In the light of the above, it has become clear that when high dielectric constant materials or insulating materials such as silicon oxide and nitride and polysilicon are etched using the semiconductor surface treatment agent of the present invention, high dielectric constant materials such as Al₂O₃, HfO₂, HfSiON, Ta₂O₅ and ZrO₂ can be selectively and efficiently etched with low corrosion to insulating materials such as silicon oxide and nitride and polysilicon and metallic materials.

[Table 1]

**Table 1**

| | | Fluorine compound | | Acid | | Water-soluble organic solvent | | Treatment temperature | High dielectric constant insulating material | Etching selection ratio of high dielectric constant insulating material and insulating material |
|---|---|---|---|---|---|---|---|---|---|---|
| | | Species | Concentration (% by mass) | Species | Concentration (% by mass) | Species | Concentration (% by mass) | °C | HfO₂ | HfO₂/th-SiO₂ |
| | 1 | Hydrofluoric acid | 2.0 | Hydrochloric acid | 1.0 | Dipropylene glycol monomethyl ether | 90 | 25 | ○ | ○ |
| | 2 | Hydrofluoric acid | 1.5 | Sulfuric acid | 6.0 | Dimethyl sulfoxide | 30 | 30 | ○ | ○ |
| | 3 | Hydrofluoric acid | 0.5 | Nitric acid | 2.0 | γ-Butyrolactone | 3.0 | 40 | ○ | ○ |
| | 4 | Hydrofluoric acid | 1.0 | Amidosulfuric acid | 1.0 | Isopropanol | 50 | 26 | ○ | ○ |
| | 5 | Tetramethylammonium fluoride | 5.0 | Hydrochloric acid | 3.0 | Diethylene glycol monobutyl ether | 45 | 25 | ○ | ○ |
| | 6 | Tetramethylammonium fluoride | 7.5 | Sulfuric acid | 12 | Benzonitrile | 30 | 30 | ○ | ○ |
| Ex. | 7 | Tetramethylammonium fluoride | 2.5 | Nitric acid | 6.0 | Ethyl acetate | 3.0 | 40 | ○ | ○ |
| | 8 | Tetramethylammonium fluoride | 5.0 | Amidosulfuric acid | 3.0 | Methanol | 50 | 25 | ○ | ○ |
| | 9 | Sodium fluoride | 1.0 | Hydrochloric acid | 1.0 | Diethylene glycol monomethyl ether | 45 | 25 | ○ | ○ |
| | 10 | Sodium fluoride | 1.5 | Sulfuric acid | 6.0 | Dimethylacetamide | 30 | 30 | ○ | ○ |
| | 11 | Sodium fluoride | 0.5 | Nitric acid | 2.0 | Tetrahydrofuran | 3.0 | 40 | ○ | ○ |
| | 12 | Sodium fluoride | 1.0 | Amidosulfuric acid | 1.0 | Ethanol | 50 | 25 | ○ | ○ |
| | 13 | Hydrofluoric acid | 1.0 | Hydrochloric acid Sulfuric acid | 1.5 | Glycerin | 50 | 25 | ○ | ○ |
| | | | | | 6.0 | | | | | |
| Comp. Ex. | 1 | Tetramethylammonium fluoride | 7.5 | - | - | - | - | 50 | × | × |
| | 2 | Hydrofluoric acid | 15 | - | - | - | - | 40 | ○ | × |
| | 3 | - | - | Hydrochloric acid | 36 | - | - | 50 | × | × |
| | 4 | - | - | - | - | Dimethylacetamide | 30 | 30 | × | × |
| | 5 | Sodium fluoride | 2.0 | - | - | Ethanol | 50 | 25 | × | × |
| | 6 | - | - | Amidosulfuric acid | 1.0 | Isopropanol | 50 | 25 | × | × |
| | 7 | Tetramethylammonium fluoride | 5.0 | Propionic acid | 3.0 | Methanol | 20 | 25 | ○ | × |
| | 8 | Hydrofluoric acid | 5.0 | Nitric acid | 6.0 | Dipropylene glycol monomethyl ether | 70 | 50 | ○ | × |

| | | | | | | | | | | |
|---|---|---|---|---|---|---|---|---|---|---|
| (Note) The balance is chiefly water. | | | | | | | | | | |

[Table 2]

**Table 2**

| | | Fluorine compound | | Acid | | Water-soluble organic solvent | | Treatment temperature | High dielectric constant insulating material | Etching selection ratio of high dielectric constant insulating material and insulating material |
|---|---|---|---|---|---|---|---|---|---|---|
| | | Species | Concentration (% by mass) | Species | Concentration (% by mass) | Species | Concentration (% by mass) | °C | Al₂O₃ | Al₂O₃/th-SiO₂ |
| | 14 | Acidic ammonium fluoride | 2.0 | Hydrochloric acid | 1.5 | Dipropylene glycol monomethyl ether | 90 | 25 | ○ | ○ |
| | 15 | Acidic ammonium fluoride | 1.5 | Sulfuric acid | 4.0 | Dimethylformamide | 30 | 30 | ○ | ○ |
| | 16 | Acidic ammonium fluoride | 0.5 | Nitric acid | 2.0 | γ-Butyrolactone | 3.0 | 40 | ○ | ○ |
| | 17 | Acidic ammonium fluoride | 1.0 | Amidosulfuric acid | 3.0 | Isopropanol | 50 | 25 | ○ | ○ |
| | 18 | Ammonium fluoride | 1.0 | Hydrochloric acid | 3.0 | Diethylene glycol monobutyl ether | 45 | 25 | ○ | ○ |
| Ex. | 19 | Ammonium fluoride | 1.5 | Sulfuric acid | 8.0 | N-Methylpyrrolidone | 30 | 30 | ○ | ○ |
| | 20 | Ammonium fluoride | 0.5 | Nitric acid | 4.0 | Ethyl acetate | 3.0 | 40 | ○ | ○ |
| | 21 | Ammonium fluoride | 1.0 | Amidosulfuric acid | 6.0 | Methanol | 50 | 25 | ○ | ○ |
| | 22 | Potassium fluoride | 3.0 | Hydrochloric acid | 1.5 | Diethylene glycol monomethyl ether | 45 | 25 | ○ | ○ |
| | 23 | Potassium fluoride | 4.5 | Sulfuric acid | 4.0 | Dimethylacetamide | 30 | 30 | ○ | ○ |
| | 24 | Potassium fluoride | 1.5 | Nitric acid | 2.0 | Tetrahydrofuran | 3.0 | 40 | ○ | ○ |
| | 25 | Potassium fluoride | 3.0 | Amidosulfuric acid | 3.0 | Ethanol | 50 | 25 | ○ | ○ |
| | 26 | Acidic ammonium fluoride | 1.0 | Nitric acid | 4.0 | Glycerin | 50 | 25 | ○ | ○ |
| | | | | Hydrochloric acid | 1.5 | | | | | |
| Comp. Ex. | 9 | Acidic ammonium fluoride | 5.0 | - | - | - | - | 50 | ○ | × |
| | 10 | Ammonium fluoride | 1.0 | - | - | - | - | 40 | × | × |
| | 11 | - | - | Nitric acid | 10 | - | - | 50 | × | × |
| | 12 | - | - | - | - | Dimethylformamide | 30 | 30 | × | × |
| | 13 | Potassium fluoride | 3.0 | - | - | Ethanol | 50 | 25 | × | × |
| | 14 | - | - | Amidosulfuric acid | 6.0 | Methanol | 50 | 25 | × | × |
| | 15 | Potassium fluoride | 4.5 | Citric acid | 3.0 | Dimethylacetamide | 20 | 25 | ○ | × |
| | 16 | Ammonium fluoride | 0.5 | Propionic acid | 6.0 | Ethyl acetate | 70 | 50 | × | × |

| | | | | | | | | | | |
|---|---|---|---|---|---|---|---|---|---|---|
| (Note) The balance is chiefly water. | | | | | | | | | | |

[Table 3]

**Table 3**

| | | Fluorine compound | | Acid | | Water-soluble organic solvent | | Treatment temperature | High dielectric constant insulating material | Etching selection ratio of high dielectric constant insulating material and insulating material |
|---|---|---|---|---|---|---|---|---|---|---|
| | | Species | Concentration (% by mass) | Species | Concentration (% by mass) | Species | Concentration (% by mass) | °C | HfSiON | HfSiON/th-SiO₂ |
| | 27 | Acidic ammonium fluoride | 2.0 | Hydrochloric acid | 1.5 | Dipropylene glycol monomethyl ether | 90 | 25 | ○ | ○ |
| | 28 | Acidic ammonium fluoride | 1.5 | Sulfuric acid | 6.0 | Dimethylformamide | 30 | 30 | ○ | ○ |
| | 29 | Acidic ammonium fluoride | 0.5 | Nitric acid | 2.0 | γ-Butyrolactone | 3.0 | 40 | ○ | ○ |
| | 30 | Acidic ammonium fluoride | 1.0 | Amidosulfuric acid | 3.0 | Isopropanol | 50 | 25 | ○ | ○ |
| | 31 | Tetramethylammonium fluoride | 7.5 | Hydrochloric acid | 3.0 | Diethylene glycol monobutyl ether | 45 | 25 | ○ | ○ |
| Ex. | 32 | Tetramethylammonium fluoride | 5.0 | Sulfuric acid | 12 | N-Methylpyrrolidone | 30 | 30 | ○ | ○ |
| | 33 | Tetramethylammonium fluoride | 2.5 | Nitric acid | 4.0 | Ethyl acetate | 3.0 | 40 | ○ | ○ |
| | 34 | Tetramethylammonium fluoride | 5.0 | Amidosulfuric acid | 6.0 | Methanol | 45 | 25 | ○ | ○ |
| | 35 | Potassium fluoride | 3.0 | Hydrochloric acid | 1.5 | Diethylene glycol monomethyl ether | 45 | 25 | ○ | ○ |
| | 36 | Potassium fluoride | 4.5 | Sulfuric acid | 6.0 | Dimethylacetamide | 30 | 30 | ○ | ○ |
| | 37 | Potassium fluoride | 1.5 | Nitric acid | 2.0 | Tetrahydrofuran | 3.0 | 40 | ○ | ○ |
| | 38 | Potassium fluoride | 3.0 | Amidosulfuric acid | 3.0 | Ethanol | 50 | 25 | ○ | ○ |
| | 39 | Hydrofluoric acid | 1 | Nitric acid | 2.0 | Glycerin | 50 | 25 | ○ | ○ |
| | | | | Amidosulfuric acid | 3.0 | | | | | |
| Comp. Ex. | 17 | Tetramethylammonium fluoride | 7.5 | - | - | - | - | 50 | × | × |
| | 18 | Hydrofluoric acid | 15 | - | - | - | - | 40 | ○ | × |
| | 19 | - | - | Amidosulfuric acid | 5.0 | - | - | 50 | × | × |
| | 20 | - | - | - | - | Ethyl acetate | 3.0 | 40 | × | × |
| | 21 | Acidic ammonium fluoride | 1.5 | - | - | Dimethylformamide | 30 | 30 | × | × |
| | 22 | - | - | Amidosulfuric acid | 1.5 | Diethylene glycol monomethyl ether | 45 | 25 | × | × |
| | 23 | Acidic ammonium fluoride | 0.5 | Malonic acid | 3.0 | Methanol | 20 | 25 | × | × |
| | 24 | Potassium fluoride | 3.0 | Succinic acid | 6.0 | Methanol | 70 | 50 | ○ | × |

| | | | | | | | | | | |
|---|---|---|---|---|---|---|---|---|---|---|
| (Note) The balance is chiefly water. | | | | | | | | | | |

## Claims

1. A semiconductor surface treatment agent comprising a fluorine compound, a water-soluble organic solvent and an inorganic acid, with the balance being water.

2. The semiconductor surface treatment agent according to claim 1, wherein the amount of the fluorine compound is from 0. 001 to 10 % by weight, the amount of the water-soluble organic solvent is from 1 to 99 % by weight, and the amount of the inorganic acid is from 0.01 to 50 % by weight.

3. The semiconductor surface treatment agent according to claim 1 or 2, wherein the fluorine compound is at least member selected among hydrofluoric acid, ammonium fluoride, acidic ammonium fluoride, tetramethylammonium fluoride, sodium fluoride and potassium fluoride.

4. The semiconductor surface treatment agent according to claim 1 or 2, wherein the water-soluble organic solvent is at least one member selected among lactones, sulfoxides, nitriles, alcohols, esters, glycol ethers and amides.

5. The semiconductor surface treatment agent according to claim 1 or 2, wherein the inorganic acid is at least one member selected among sulfuric acid, nitric acid, hydrochloric acid, phosphoric acid, sulfamic acid, nitrous acid and amidosulfuric acid.

6. A method for manufacturing a semiconductor device comprising etching a high dielectric constant insulating material using the semiconductor surface treatment agent according to any one of claims 1 to 5.
